# EUROPEAN PATENT APPLICATION

(11) **EP 4 797 203 A1**
(43) Date of publication of application: **26.08.2026**
(21) Application number: 26160056.3
(22) Date of filing: 23.02.2026
(51) Int. Cl.: G06T 7/00, G06T 17/20

(54) **SYSTEMS AND METHODS FOR DETERMINING PROPERTIES OD A COMPOSITE MATERIAL**

(30) Priority: 24.02.2025 US 202519061362
(71) Applicant: DASSAULT SYSTEMES AMERICAS CORP., Waltham, MA 02451 (US)
(72) Inventor: Sun, Zhuang, Austin, TX (US); Salazar-Tio, Rafael, San Ramon, CA (US); Fager, Andrew, S. Edina, MN (US)
(74) Representative: Bandpay & Greuter

(57) **Abstract**

Embodiments determine properties of composite materials. One such embodiment obtains, in a memory, an image of a composite material. The obtained image is segmented to identify a plurality of phases in the composite material. Based on the obtained image and plurality of phases identified, at least one transformed image of the composite material is generated indicating change in the plurality of phases identified. For each generated at least one transformed image, a finite element (FE) model is constructed. A simulation of the composite material is performed using each FE model constructed to determine at least one property of the composite material.

## Description

### BACKGROUND

Composite materials, *e.g.,* cement and concrete, are widely used across a number of industries. Among other examples, composite materials have become essential in construction. Given the widespread utilization of composite materials, accurately determining the properties, *e.g.,* mechanical properties, of composite materials is important from both an engineering and safety perspective. Some existing technologies rely on, *inter alia,* imaging methodologies and/or techniques to predict properties from three-dimensional (3D) microstructure(s) of a composite material.

### SUMMARY

Problematically, existing techniques for predicting properties of composite materials fail to consider both changes in 3D microstructure and properties of the material due to, *e.g.,* carbonation reactions. For instance, to predict global properties for cement, some conventional approaches perform a homogenization process based on pre-established percentages for the different materials making up the cement, *e.g.,* 50% is material A, 20% is material B, and the remaining 30% is material C. These approaches may be used to predict properties for cement, but they have subpar accuracy. Another shortcoming of such conventional approaches is that they only consider percentages of different materials in a composite, without accounting for spatial distribution of the materials and/or specific aspects, *e.g.,* speed, of a reaction taking place, *e.g.,* a carbonation reaction. Some other traditional approaches rely on image segmentation techniques that have inferior performance. Therefore, functionality with improved accuracy, performance, and efficacy for determining properties of a composite material, *e.g.,* concrete or cement, is needed. Embodiments provide such functionality.

An example embodiment for determining properties of a composite material may extract segmentation of phases of the material from images, e.g., micro-computed tomography (micro-CT) images, of the material. Another example embodiment may perform image processing, *e.g.,* segmentation, to simulate or mimic chemical reactions, *e.g.,* carbonation reactions. Yet another example embodiment may create a finite element (FE) model in, *e.g.,* Abaqus^{®} (Dassault Systèmes Americas Corp., Waltham, MA), assign material properties to different phases in the model, and set up stress/strain boundary conditions in the model. An example embodiment may determine properties, *e.g.,* mechanical properties, of a composite material according to different degrees of carbonation of the material.

Further, simulation results of example embodiments can be validated with laboratory experimental data.

It should be noted that embodiments can perform n-phase segmentation of a composite material. In other words, embodiments are not limited to segmenting a particular number of phases (or types of phases) of composite materials. For example, if a new material is developed for cement, embodiments can successfully segment the new material in addition to the existing materials in cement.

An example embodiment can predict properties of a composite material under chemical reactions based on inputs including phase material properties and 3D microstructure, for non-limiting examples. In another example embodiment, a 3D microstructure can be obtained from images, *e.g.,* micro-CT images, or virtual microstructures created by, *e.g.,* hydration models.

Further, some embodiments relate to simulation.

An example embodiment is directed to a computer-implemented method for determining properties of a composite material. The method begins by obtaining, in a memory, an image of a composite material. Next, the obtained image is segmented to identify a plurality of phases in the composite material. Based on the obtained image and plurality of phases identified, the method then generates at least one transformed image of the composite material. The at least one transformed image indicates change in the plurality of phases identified. For each generated at least one transformed image, the method constructs a FE model. In turn, a simulation of the composite material is performed using each FE model constructed to determine at least one property of the composite material. According to an example embodiment, the composite material is concrete or cement.

In an example embodiment, the change in the plurality of phases identified may be a result of a chemical reaction. According to one such example embodiment, the chemical reaction may be a carbonation reaction.

In an example embodiment, generating a given transformed image, of the at least one transformed image, based on the obtained image and plurality of phases identified may include iterating, until a chemical reaction is completed: (1) using the obtained image, identifying a contact surface between a first phase and a second phase of the plurality of phases identified; (2) determining an exchange, resulting from progression of the chemical reaction, between (i) at least one of the first phase and the second phase and (ii) a product of the chemical reaction; and (3) based on the exchange determined, updating the obtained image by propagating a conversion from the contact surface identified to the first phase and the second phase until a threshold is met. To continue, in such an embodiment, responsive to determining the chemical reaction is completed, the given transformed image is generated based on the obtained image updated. In one such embodiment, the first phase and the second phase are reactants in the chemical reaction. According to another such embodiment, in a first iteration, the contact surface may be identified using the obtained image, and, in each iteration subsequent to the first iteration, the contact surface may be identified using the obtained image updated, from a previous iteration. In another such embodiment, the first phase and the second phase may include a resolved pore and at least one mineral. According to yet another such embodiment, the exchange may be a volumetric ratio. In one such embodiment, the exchange may be determined based on any combination of density, porosity, and stochiometric ratio. According to another such embodiment, the conversion may be propagated based on a 3D voxel-based growing model. In yet another such embodiment, the method may further include performing a posterior characterization of the composite material based on the obtained image updated. According to one such embodiment, performing the posterior characterization of the composite material may include determining, based on microstructure of the composite material indicated by the obtained image updated, at least one of elastic moduli and effective diffusivity.

According to another example embodiment, the segmenting may include determining a respective label corresponding to each phase of the plurality of phases identified. In one such embodiment, a given respective label determined may include one of: a resolved pore, calcium silicate hydrate (CSH), portlandite (*i.e.,* calcium hydroxide (CH)), and clinker (*i.e.,* an unhydrated phase).

In an example embodiment, each FE model constructed may correspond to a respective porosity of the composite material. According to one such embodiment, performing the simulation may include using each FE model constructed corresponding to the respective porosity to determine the at least one property of the composite material as a function of porosity.

According to another example embodiment, the determined at least one property may include at least one of Young's modulus and shear modulus.

In an example embodiment, constructing the FE model may include configuring, for the FE model, at least one of a stress boundary condition and a strain boundary condition.

Another example embodiment is directed to a computer-based system for determining properties of a composite material. The system includes a processor and a memory with computer code instructions stored thereon. The processor and the memory, with the computer code instructions, are configured to cause the system to implement any embodiments or combination of embodiments described herein.

Yet another embodiment is directed to a computer program product for determining properties of a composite material. The computer program product includes a non-transitory computer-readable medium with computer code instructions stored thereon. The computer code instructions are configured, when executed by a processor, to cause an apparatus associated with the processor to implement any embodiments or combination of embodiments described herein. A further embodiment is directed to a computer program for determining properties of a composite material. The computer program code instructions configured, when executed by a processor, to cause an apparatus associated with the processor to implement any embodiments or combination of embodiments described herein.

It is noted that embodiments of the method, system, and computer program product may be configured to implement any embodiments or combination of embodiments described herein.

### BRIEF DESCRIPTION OF THE DRAWINGS

The patent or application file contains at least one drawing executed in color. Copies of this patent or patent application publication with color drawing(s) will be provided by the Office upon request and payment of the necessary fee.

The foregoing will be apparent from the following more particular description of example embodiments, as illustrated in the accompanying drawings in which like reference characters refer to the same parts throughout the different views. The drawings are not necessarily to scale, emphasis instead being placed upon illustrating embodiments.
FIG. 1A is an example image of a composite material, according to an embodiment.
FIG. 1B illustrates an example segmentation of the image of FIG. 1A, according to an embodiment.
FIG. 2 depicts example cross-sectional views showing changes in microstructure of cement, according to an embodiment.
FIG. 3A depicts an example FE model with different mineral phases, according to an embodiment.
FIG. 3B depicts an example simulation result of stress distribution for the FE model of FIG. 3A, according to an embodiment.
FIGs. 4A and 4B are example graphs of simulation results of changes in Young's modulus and shear modulus, respectively, according to embodiments.
FIG. 5 is an example graph illustrating validation of an example embodiment with laboratory experimental results.
FIG. 6 is an example graph illustrating changes of relative diffusivity of cement, according to an embodiment.
FIG. 7 is a flowchart of a method for determining properties of a composite material according to an example embodiment.
FIG. 8 is a schematic view of a computer network in which embodiments may be implemented.
FIG. 9 is a block diagram illustrating an example embodiment of a computer node in the computer network of FIG. 8.

### DETAILED DESCRIPTION

A description of example embodiments follows.

Composite materials are widely used across a number of industries. For instance, one non-limiting example of a composite material, cement, is widely used in construction. Given the widespread use of composite materials, it has become increasingly important to know the properties, e.g., mechanical properties, of composite materials. In the past several decades, advancements in computing resources, algorithms, and imaging techniques have made it possible to predict mechanical properties of composite materials based on 3D microstructures of the composite materials. However, there is no existing methodology that focuses on both the changes of 3D microstructures and mechanical properties of composite materials due to chemical reactions.

In the example of cement, carbon dioxide (CO₂) from either the air or underground storage can react with hydrated materials in the cement. This chemical process, which is called a carbonation reaction, has a significant impact on the properties and durability of cement. Cement mechanical properties are conditioned by the cement's 3D microstructure. As noted above, while advancements in computing resources, algorithms, and imaging techniques have made it possible to predict cement mechanical properties from 3D microstructures, there is no work that focuses on both the changes of 3D microstructure and mechanical properties of the cement due to the carbonation reactions (which cause changes to the 3D microstructure). Embodiments provide such functionality. Further, it is noted that embodiments are not limited to determining mechanical properties of cement; rather, embodiments can be used to determine any type of properties for any type of composite material.

A non-limiting example application of embodiments is a subsurface wellbore. Wellbores may have cement injected into the subsurface. Further, CO₂ may be injected into the subsurface for storage, *e.g.,* for purposes of CO₂ sequestration. The stored CO₂ may react with the wellbore cement in a carbonation reaction, thereby changing or altering properties of the cement. Such reactions and resulting changes in cement properties can endanger the integrity of the wellbore. In turn, if wellbore integrity is compromised-due to, e.g., cement degradation-then CO₂ leakage can occur, which undermines effective storage of CO₂. Embodiments can determine changes in properties of cement in a wellbore due to carbonation and other reactions. By utilizing embodiments, wellbore cement degradation can be analyzed or forecasted, thus allowing for such degradation to be mitigated or avoided entirely. For instance, embodiments can be used to design wellbores that withstand degradation and successfully sequester CO₂ over time. Likewise, embodiments may be used to determine properties of an existing wellbore, identify current properties of the wellbore, and forecast future properties of the wellbore. These determined properties can be used to determine design changes, e.g., fixes, to the wellbore to prevent problems, e.g., CO₂ leakage.

It should be noted, however, that embodiments are not limited to determining mechanical properties of cement in, *e.g.,* a wellbore. For instance, cement is used in a vast number of different applications aside from wellbores. CO₂ in the natural environment or the atmosphere can also react with cement in a wide variety of circumstances. Embodiments are useful for these other types of cement applications and other types of reaction conditions as well. Even more generally, embodiments are not limited to cement or to determining mechanical properties. Rather, embodiments can also determine other types of properties for other types of composite materials.

### Example Simulation Workflow

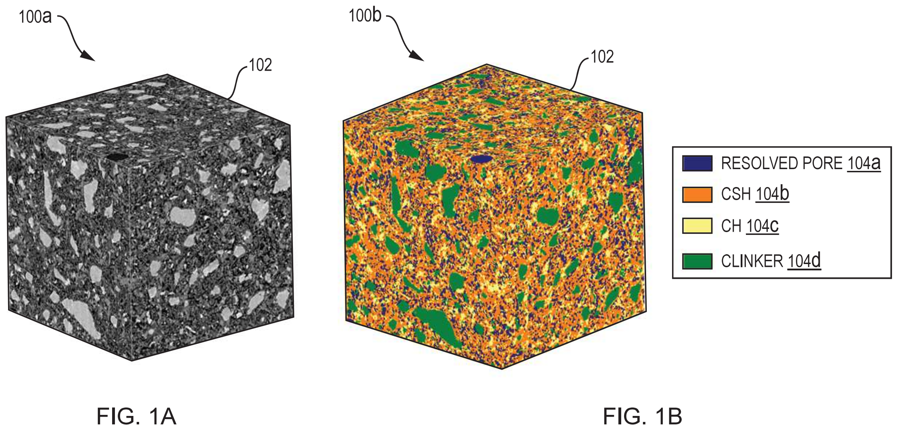

FIG. 1A is an example greyscale image 100a of cement 102, according to an embodiment. FIG. 1B is an example segmented image 100b of the cement 102 of FIG. 1A indicating various mineral phases including resolved pore 104a, CSH 104b, CH 104c, and clinker 104d, according to an embodiment. As described hereinbelow, embodiments may take an image of a composite material, *e.g.,* the image 102, and, from the image of the composite material, determine phases of the composite material, e.g., as shown in the image 100b.

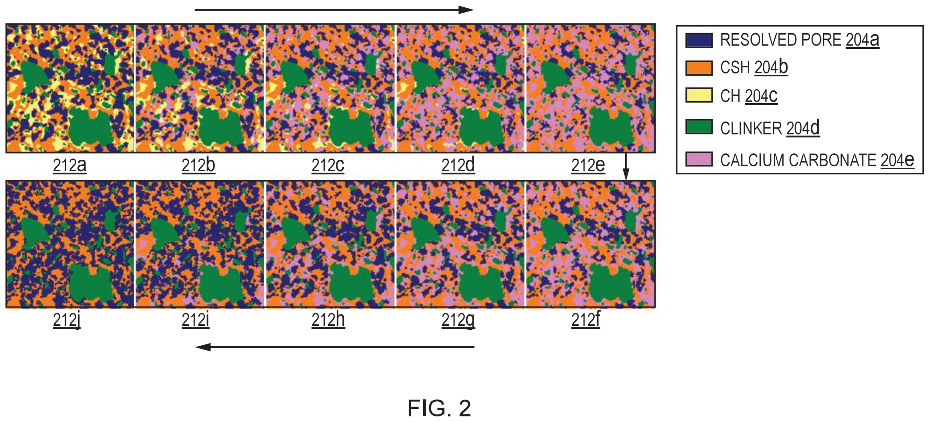

FIG. 2 depicts example two-dimensional (2D) cross-sectional views 212a-212j of a cement microstructure. Specifically, the view 212a shows noncarbonated cement, the views 212b-212e show dry carbonated cement, and the views 212f-212j show wet carbonated cement, according to an embodiment. As shown in FIG. 2, in an example embodiment, the views 212a-212j indicate various mineral phases including resolved pore 204a, CSH 204b, CH 204c, clinker 204d, and/or calcium carbonate 204e. More specifically, the views 212a-212j show changes in the phases 204a-204e of the cement as the cement goes from noncarbonated (the view 212a), to dry carbonated (the views 212b-212e), to wet carbonated (the views 212f-212j). It should be noted that the 2D views 212a-212j of FIG. 2 are example images and embodiments may also use, *e.g.,* 3D blocks or 3D microstructures, to determine properties of composite materials.

Continuing with FIG. 2, among the different phases 204a-204e, the CH 204c (*i.e.,* Ca(OH)₂) may react fastest with CO₂ (not shown) during the dry carbonation (shown across the views 212b-212e) to form the calcium carbonate 204e (*i.e.,* CaCO₃), as well as water (not shown). As the CO₂ moves through the pores 204a, the CO₂ can react wherever a pore 204a is next to the CH 204c. Such changes are shown across the views 212b-212e, where portions of the pores 204a that interact with the CH 204c are converted to the calcium carbonate 204e. Embodiments may follow rules for a given reaction to gradually convert the CH 204c to the calcium carbonate 204e. In this way, embodiments may determine how structure, *e.g.,* microstructure, of cement changes over time. These changes in structure may be used to determine properties of the cement.

Continuing further with FIG. 2, when the dry carbonation reaction shown across the views 212b-212e reaches the point shown in the view 212e in the top right corner, all the CH 204c may be depleted. However, if CO₂ continues to be introduced, the CO₂ can react with and dissolve the solid calcium carbonate 204e. The result of this may be additional resolved pores 204a. Such changes are shown across the views 212f-212j, where the calcium carbonate 204e decreases and additional pores 204a emerge.

In an embodiment, an example workflow for determining properties of a composite material may take as an input a voxelized image, *e.g.,* a 3D voxelized image, of the composite material, e.g., the image 100a of the cement 102 (FIG. 1A). According to another example embodiment, the image 100a may capture a representative elemental volume of the cement 102, with enough resolution to identify different phases. In yet another example embodiment, a real-world microstructure obtained from a micro-CT image in the National Institute of Standards and Technology (NIST) Visible Cement Dataset may be used as an input. The dataset is open and has been used for extracting various effective properties of cement. However, it should be noted that other types of known images and/or image sources are also suitable.

To continue, in an embodiment, a workflow for determining properties of a composite material may include the following example steps.

First, an input image, *e.g.,* the 3D voxelized image 100a (FIG. 1A), may be segmented to label individual voxels as belonging to different phases including, e.g., mineral phases of resolved pores 104a, CSH 104b, CH 104c, and clinker 104d (FIG. 1B). According to an example embodiment, image segmentation may be performed by thresholding both gray levels and their gradients, which tends to avoid unrealistic segmentation of one mineral encircling another mineral typically produced by conventional approaches.

Second, an example image processing technique may be employed to mimic carbonation reactions including dry carbonation (*i.e.,* carbonation), *e.g.,* shown across the views 212b-212e in FIG. 2, and/or wet carbonation (*i.e.,* bicarbonation), *e.g.,* shown across the views 212f-212j in FIG. 2, which tend to have opposite impacts or effects on, *e.g.,* cement mechanical properties, for instance as depicted in FIG. 2. In an embodiment, the example image processing for the dry carbonation may include identifying voxels with intersections of the resolved pore 204a (FIG. 2) and the CH 204c (FIG. 2), which intersections can be used as seeding points to grow products of the reactions. Growing the products may include not only substituting the CH 204c (FIG. 2) with the calcium carbonate 204e (FIG. 2), but also simulating an invasion of the resolved pore 204a by the calcium carbonate 204e. In this way, materials (*i.e.,* the phases 204a-204e) may be replaced at the appropriate locations. Processing for the dry carbonation may continue in a systematic fashion until the CH 204c is entirely consumed. An example embodiment may also faithfully adhere to the stoichiometrics of the dry carbonation reaction (shown across the views 212b-212e) and the wet carbonation reaction (shown across views 212f-212j). To continue, for the wet carbonation, the calcium carbonate 204e in contact with the resolved pore 204a may then be eliminated. Embodiments may utilize information regarding density and/or volumetrics as part of the example image processing technique.

Third, in such an example embodiment, the labeled voxelized 3D image may be transformed into a structured mesh representation that is identical to the image voxels through, *e.g.,* Python scripts or other suitable known software programming techniques. The meshed model may then be input into a FE solver, *e.g.,* as part of the Abaqus^{®} application by Applicant-Assignee Dassault Systèmes Americas Corporation, and strain/stress boundary conditions may also be configured, *e.g.,* by utilizing an Abaqus^{®} micromechanics plugin. It is noted that while embodiments are described herein as utilizing tools and platforms by Applicant-Assignee Dassault Systèmes Americas Corporation and Dassault Systèmes, embodiments are not limited to such tools and platforms; rather, similar known tools and platforms are also suitable.

Fourth, and finally, simulation steps for homogenization may be performed and a stiffness matrix may be calculated, *e.g.,* of cement under various carbonation conditions.

### Example Simulation Results

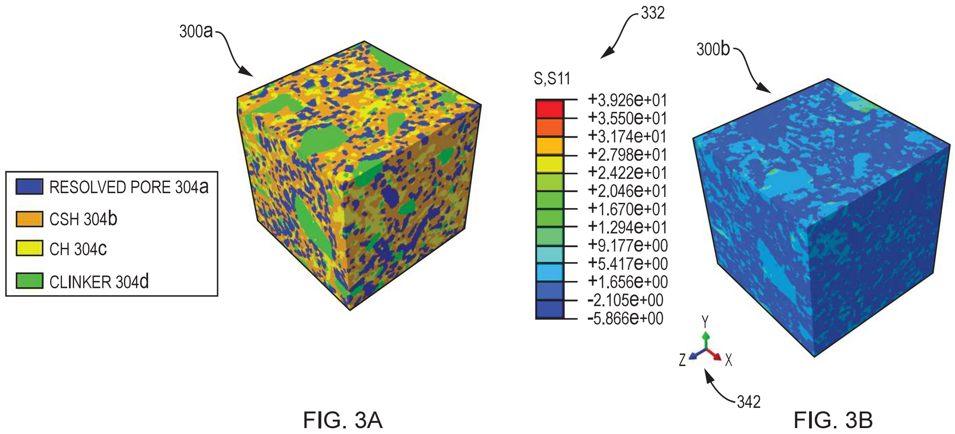

FIG. 3A depicts an example meshed model 300a with different colors representing different mineral phases 304a-304d, according to an embodiment. FIG. 3B shows an example simulation result 300b for the meshed model 300a of FIG. 3A, according to an embodiment.

To generate example test results shown in FIGs. 3A and 3B, an embodiment utilized a sub-volume of an entire cement microstructure and the resulting meshed model 300a was imported to Abaqus^{®} to achieve a desired balance between computational cost and accuracy. Further, an embodiment applied six example loading cases including compressions in three directions and shears in three directions to obtain a symmetric 6x6 stiffness matrix of the cement. FIG. 3A shows the meshed model 300a and FIG. 3B shows the simulation result 300b of stress distribution 332 under an example compression loading case. In the legend 332, notation "S11" refers to stress in the 1-direction (*i.e.,* x-direction), which is one horizontal direction in FIG. 3B, as shown by indicator 342. The aforementioned stiffness matrix (not shown) includes two example mechanical properties of cement: Young's modulus and shear modulus.

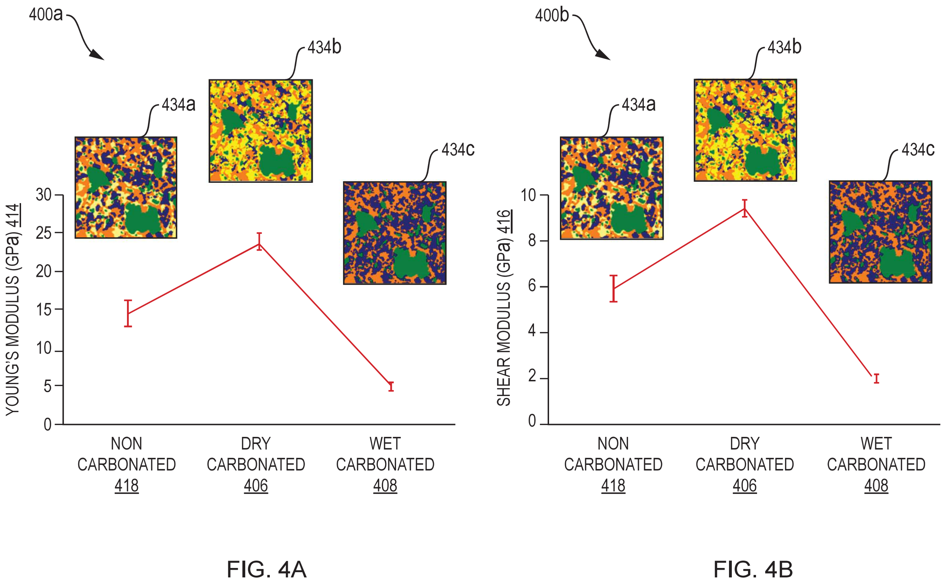

FIG. 4A is an example graph 400a of simulation results of changes in Young's modulus 414, *e.g.,* in gigapascals (GPa), and FIG. 4B is an example graph 400b of simulation results of changes in shear modulus 416 for noncarbonated 418, dry carbonated 406, and wet carbonated 408 cement as carbonation reactions proceed, according to embodiments. The graphs 400a and 400b also include views 434a-434c illustrating the cement and associated phases while noncarbonated 418, dry carbonated 406, and wet carbonated 408, respectively.

As shown respectively in FIGs. 4A and 4B, in an example embodiment, generally speaking, the dry carbonation 406 tends to increase the mechanical properties 414 and 416, whereas the wet carbonation 408 tends to decrease the mechanical properties 414 and 416.

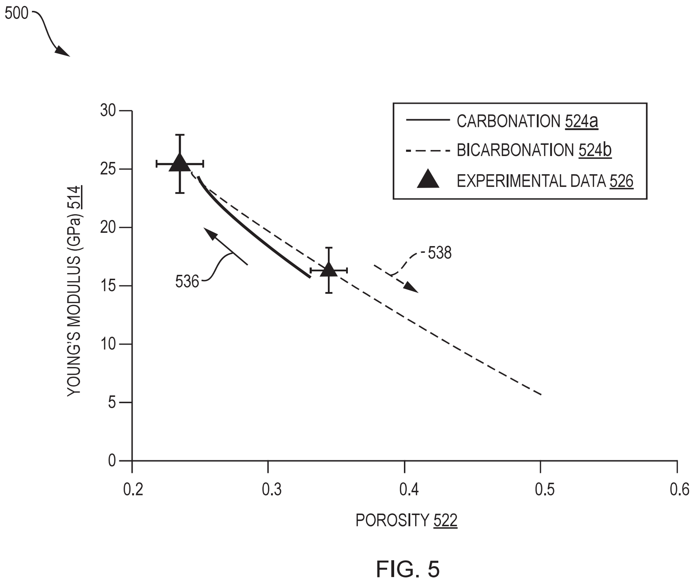

FIG. 5 is an example graph 500 of Young's modulus 514 versus porosity 522 illustrating validation of simulation results for carbonation 524a and bicarbonation 524b with laboratory experimental results 526, according to an embodiment. In the plot 500, arrows 536 and 538 indicate time evolution of the carbonation 524a and bicarbonation 524b reactions, respectively. For instance, at the beginning of the carbonation reaction 524a, the Young's modulus 514 is approximately 15 GPa, and at the end of the carbonation reaction 524a, the Young's modulus 514 is approximately 25 GPa. At the beginning of the bicarbonation reaction 524b, the Young's modulus 514 is approximately 25 GPa, and at the end of the bicarbonation reaction 524b, the Young's modulus 514 is approximately 5 GPa.

Simulation results of an embodiment were validated with the laboratory experimental data 526. The experiment used ordinary Portland cement mixed with water, which was under a very similar condition of the simulation. The sample was completely dry carbonated and the Young's moduli 514 were measured for both noncarbonated and dry carbonated samples. FIG. 5 shows the comparison between the simulation results 524a and 524b of an embodiment and the laboratory experimental results 526, which proves the accuracy of embodiments. The simulation results show that the dry 524a and wet 524b carbonation reactions lead to a non-trivial evolution of the constitutive relationship, *i.e.,* the way in which a composite material such as cement responds or behaves as a result of chemical reaction(s).

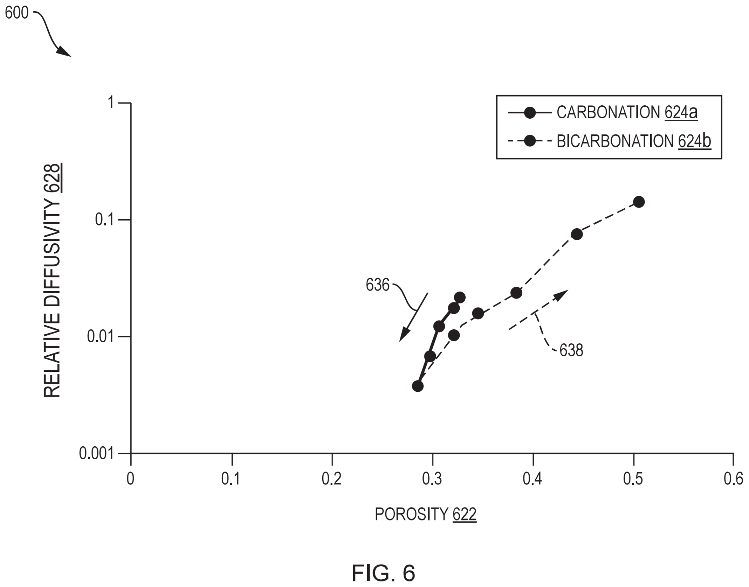

FIG. 6 is an example graph 600 illustrating changes of relative diffusivity 628 versus porosity 622 of cement for carbonation 624a and bicarbonation 624b reactions, according to an embodiment. In the plot 600, arrows 636 and 638 indicate time evolution of the carbonation 624a and bicarbonation 624b reactions, respectively. For instance, at the beginning of the carbonation reaction 624a, the relative diffusivity 628 is approximately 0.05, and at the end of the carbonation reaction 624a, the relative diffusivity 628 is approximately 0.005. At the beginning of the bicarbonation reaction 624b, the relative diffusivity 628 is approximately 0.005, and at the end of the bicarbonation reaction 624b, the relative diffusivity 628 is approximately 0.1.

Besides elastic properties, an example workflow of embodiments can also be applied to obtain other composite material properties, *e.g.,* of cement. One non-limiting example is cement diffusivity. FIG. 6 shows example changes in the relative diffusivity 628 as the carbonation reactions 624a and 624b proceed, according to an embodiment. In an example embodiment, the relative diffusivity 628 may be defined as a ratio of microstructure effective diffusivity and bulk diffusivity. The example results depicted in the graph 600 indicate that the dry carbonation 624a tends to decrease the relative diffusivity 628, whereas the wet carbonation 624b tends to increase the relative diffusivity 628. A hysteresis for the dry 624a and wet 624b carbonations can also be observed, similar to the evolution of Young's modulus 514 in FIG. 5.

### Example Method Embodiment

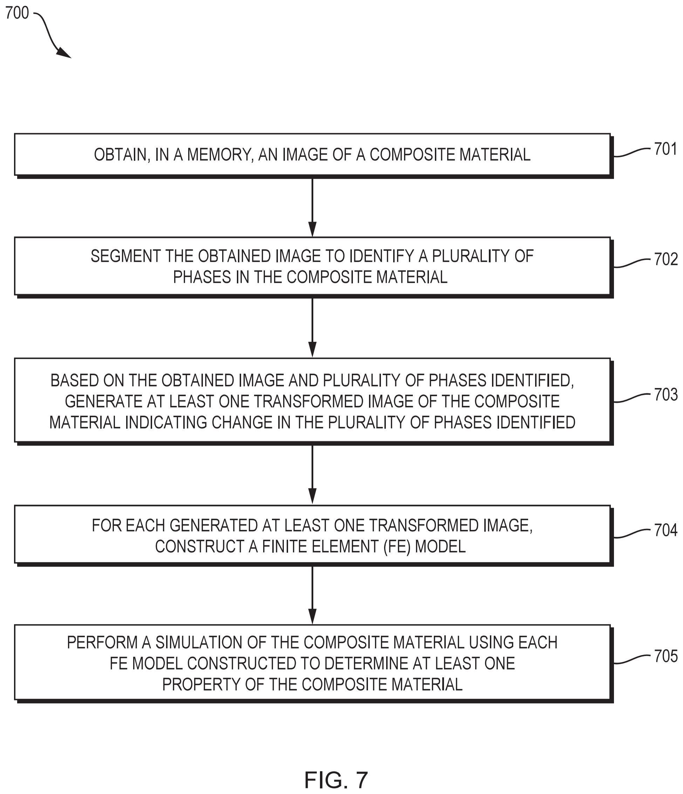

FIG. 7 is a flowchart of a method 700 for determining properties of a composite material according to an embodiment. The method 700 is computer-implemented and may be implemented using any computing device, *e.g.,* a processor, or combination of computing devices known to those of skill in the art.

The method 700 begins at step 701 by obtaining, in a memory, an image, *e.g.,* 100a (FIG. 1A), of a composite material, *e.g.,* the cement 102 (FIG. 1A). Next, at step 702, the method 700 segments the obtained image to identify a plurality of phases, e.g., 104a-104d (FIG. 1B) or 204a-204e (FIG. 2), in the composite material. At step 703, based on the obtained image and plurality of phases identified, at least one transformed image of the composite material is generated. The transformed images indicate changes in the plurality of phases identified. At step 704, for each generated at least one transformed image, a FE model, *e.g.,* 300a (FIG. 3A) is constructed. In turn, at step 705, a simulation of the composite material is performed, using each FE model constructed, to determine at least one property of the composite material.

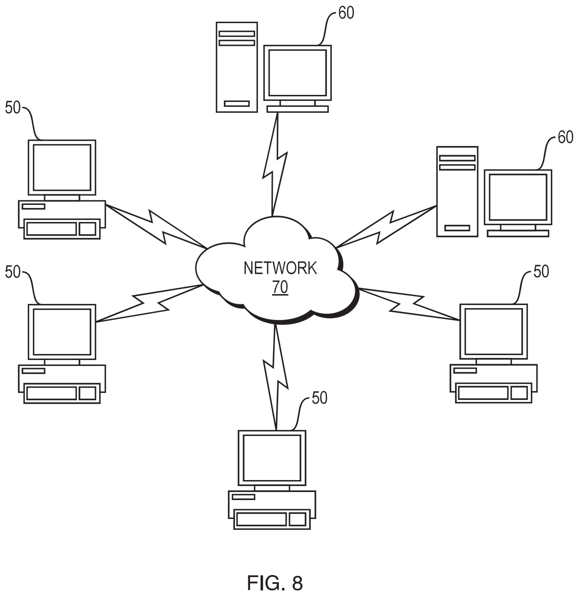

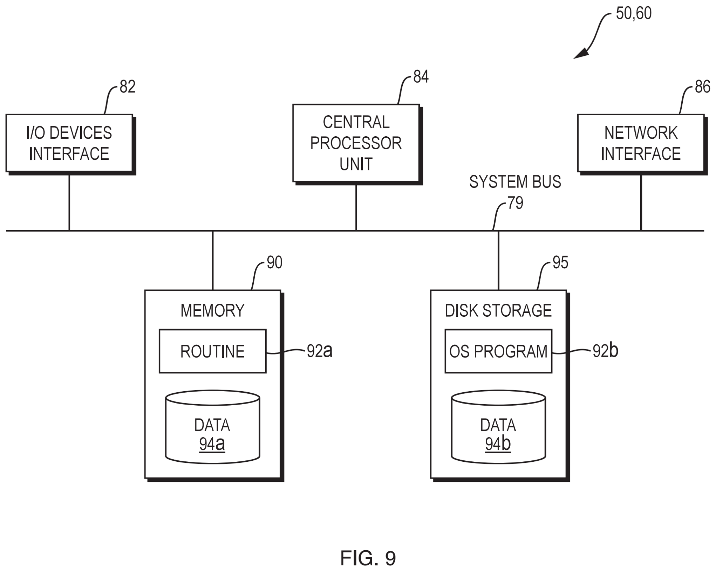

As noted, the method 700 is computer-implemented and, as such, the functionality and effective operations, *e.g.,* the obtaining (701), segmenting (702), generating (703), constructing (704), and performing (705), are automatically implemented by one or more digital processors. The method 700 can also be implemented using any computer device or combination of computing devices known in the art. Among other examples, the method 700 can be implemented using computer(s)/device(s) 50 and/or 60 described hereinbelow in relation to FIGs. 8 and 9.

Embodiments of the method 700 may obtain the image at step 701 from any source, e.g., computer storage or image capture device, communicatively coupled, or capable of being communicatively coupled, to a computing device implementing the method 700. Further, the image may be any image known to those of skill in the art. Among other examples, the image obtained at step 701 may be a 2D or 3D voxelized image.

In embodiments of the method 700, the image obtained at step 701 may be of any composite material known to those of skill in the art. Among other examples, in an embodiment of the method 700, the composite material may be concrete or cement, *e.g.,* 102 (FIG. 1A). Further, the image obtained at step 701 may be of any real-world composite material. For instance, the obtained image may be of concrete in a real-world wellbore or may be of a concrete bridge. In such applications, embodiments of the method 700 may be used to determine properties of the real-world composite material and real-world use(s) of the composite material. These properties can, in turn, be used to identify changes, *e.g.,* repairs to the real-world composite material or repairs to a larger structure that incorporates the composite material. In further embodiments, the obtained image can be of composite materials that have not yet been utilized in real-world applications. For example, the obtained image can be of a candidate composite material. In such an example implementation, the method 700 can be used to evaluate candidate composite materials and determine which materials meet requirements.

In an embodiment, the obtained image is segmented at step 702 by computing an intensity versus gradient graph and using thresholds to define different regions of minerals for seeding and growing connected regions in the obtained image. In contrast with embodiments, conventional segmentation methods that use only intensity thresholds determined from a histogram will result in an incorrect segmentation of, *e.g.,* CH and CSH. The innovative technique of embodiments helps to avoid unrealistic segmentation of, *e.g.,* one mineral encircling another mineral typically produced by conventional approaches. Embodiments can also perform n-phase segmentation of a composite material. In other words, embodiments are not limited to segmenting a particular number of phases (or types of phases) of composite materials. For example, if a new material is developed for cement, embodiments can successfully segment the new material in addition to the existing materials in cement. According to another example embodiment of the method 700, the segmenting at step 702 may include determining a respective label corresponding to each phase of the plurality of phases identified. In one such embodiment of the method 700, a given respective label determined may include one of a resolved pore, *e.g.,* 104a (FIG. 1B) or 204a (FIG. 2), CSH, *e.g.,* 104b (FIG. 1B) or 204b (FIG. 2), CH, *e.g.,* 104c (FIG. 1B) or 204c (FIG. 2), clinker, *e.g.,* 104d (FIG. 1B) or 204d (FIG. 2), and calcium carbonate, *e.g.,* 204e (FIG. 2).

According to another example embodiment of the method 700, the change in the plurality of phases identified may be a result of a chemical reaction. In one such example embodiment of the method 700, the chemical reaction may be a carbonation reaction.

In an example embodiment of the method 700, generating a given transformed image at step 703, of the at least one transformed image, based on the obtained image and plurality of phases identified may include iterating, until a chemical reaction is completed: (1) using the obtained image, identifying a contact surface between a first phase and a second phase of the plurality of phases identified; (2) determining an exchange resulting from progression of the chemical reaction, between (i) at least one of the first phase and the second phase and (ii) a product of the chemical reaction; and (3) based on the exchange determined, updating the obtained image by propagating a conversion from the contact surface identified to the first phase and the second phase until a threshold is met. According to such an embodiment, the first phase and the second phase may be reactants in the chemical reaction. To illustrate such functionality, consider FIG. 2, where in such an illustrative example an image is obtained at step 701 and segmented at step 702 to produce the segmented image 212a. At step 703, one or more of the following iterations may occur until chemical reaction(s) are completed:
a) Using the image 212a, a contact surface may be identified between a resolved pore 204a phase and a CH 204c phase. An exchange may be determined between the CH 204c phase and a product of a dry carbonation reaction in the form of calcium carbonate 204e by using, e.g., their densities, microporosities, and/or stochiometric ratios in the reaction. Based on the exchange, the image 212a may be updated by propagating a conversion from the identified contact surface to the resolved pore 204a phase and the CH 204c phase, resulting in updated image 212b.
b) Using the image 212b, a contact surface may be identified between a resolved pore 204a phase and a CH 204c phase. An exchange may be determined between the CH 204c phase and a product of the dry carbonation reaction in the form of calcium carbonate 204e. Based on the exchange, the image 212b may be updated by propagating a conversion from the contact surface to the resolved pore 204a phase and the CH 204c phase, resulting in updated image 212c.
c) Using the image 212c, a contact surface may be identified between a resolved pore 204a phase and a CH 204c phase. An exchange may be determined between the CH 204c phase and a product of the dry carbonation reaction in the form of calcium carbonate 204e. Based on the exchange, the image 212c may be updated by propagating a conversion from the contact surface to the resolved pore 204a phase and the CH 204c phase, resulting in updated image 212d.
d) Using the image 212d, a contact surface may be identified between a resolved pore 204a phase and a CH 204c phase. An exchange may be determined between the CH 204c phase and a product of the dry carbonation reaction in the form of calcium carbonate 204e. Based on the exchange, the image 212d may be updated by propagating a conversion from the contact surface to the resolved pore 204a phase and the CH 204c phase, resulting in updated image 212e.
e) Using the image 212e, a contact surface may be identified between a resolved pore 204a phase and a calcium carbonate 204e phase. An exchange may be determined between the calcium carbonate 204e phase and a product of a wet carbonation reaction in the form of a resolved pore 204a. Based on the exchange, the image 212e may be updated by propagating a conversion from the contact surface to the resolved pore 204a phase and the calcium carbonate 204e phase, resulting in updated image 212f.
f) Using the image 212f, a contact surface may be identified between a resolved pore 204a phase and a calcium carbonate 204e phase. An exchange may be determined between the calcium carbonate 204e phase and a product of the wet carbonation reaction in the form of a resolved pore 204a. Based on the exchange, the image 212f may be updated by propagating a conversion from the contact surface to the resolved pore 204a phase and the calcium carbonate 204e phase, resulting in updated image 212g.
g) Using the image 212g, a contact surface may be identified between a resolved pore 204a phase and a calcium carbonate 204e phase. An exchange may be determined between the calcium carbonate 204e phase and a product of the wet carbonation reaction in the form of a resolved pore 204a. Based on the exchange, the image 212g may be updated by propagating a conversion from the contact surface to the resolved pore 204a phase and the calcium carbonate 204e phase, resulting in updated image 212h.
h) Using the image 212h, a contact surface may be identified between a resolved pore 204a phase and a calcium carbonate 204e phase. An exchange may be determined between the calcium carbonate 204e phase and a product of the wet carbonation reaction in the form of a resolved pore 204a. Based on the exchange, the image 212h may be updated by propagating a conversion from the contact surface to the resolved pore 204a phase and the calcium carbonate 204e phase, resulting in updated image 212i.
i) Using the image 212i, a contact surface may be identified between a resolved pore 204a phase and a calcium carbonate 204e phase. An exchange may be determined between the calcium carbonate 204e phase and a product of the wet carbonation reaction in the form of a resolved pore 204a. Based on the exchange, the image 212i may be updated by propagating a conversion from the contact surface to the resolved pore 204a phase and the calcium carbonate 204e phase, resulting in updated image 212j.

According to one such embodiment of the method 700, in a first iteration, the contact surface may be identified using the obtained image, and, in each iteration subsequent to the first iteration, the contact surface may be identified using the obtained image updated, from a previous iteration. In another such embodiment of the method 700, the first phase and the second phase may include a resolved pore and at least one mineral. According to yet another such embodiment of the method 700, the exchange may be a volumetric ratio. In one such embodiment of the method 700, the exchange may be determined based on any combination of density, porosity, and stochiometric ratio. According to another such embodiment of the method 700, the conversion may be propagated based on a 3D voxel-based growing model. In yet another such embodiment, the method 700 may further include performing a posterior characterization of the composite material based on the obtained image updated. According to one such embodiment of the method 700, performing the posterior characterization of the composite material may include determining, based on microstructure of the composite material indicated by the obtained image updated, at least one of elastic moduli and effective diffusivity.

According to an embodiment, a FE model is constructed at step 704 by, for instance, converting the at least one transformed image into a meshed model. For example, the FE model may adopt hexahedral elements that are identical to the image voxels. In an example embodiment of the method 700, each FE model constructed may correspond to a respective porosity, *e.g.,* 522 (FIG. 5) or 622 (FIG. 6), of the composite material. Returning to the example of FIG. 2, where each view 212b-212j is a transformed image resulting from step 703 (where the composite material in each view 212b-212j has a respective porosity), at step 704, a respective FE model is generated based on each transformed image and, thus, each respective FE model corresponds to a respective porosity. According to one such embodiment of the method 700, performing the simulation may include using each FE model constructed corresponding to a respective porosity to determine the at least one property of the composite material as a function of porosity. In an example embodiment of the method 700, constructing the FE model at step 704 may include configuring, for the FE model, at least one of a stress boundary condition and a strain boundary condition. For instance, strain and/or stress boundary conditions may be configured, *e.g.,* by utilizing an Abaqus^{®} micromechanics plugin, which may facilitate assignment of a small displacement/loading in, *e.g.,* six directions (such as three normal directions and three shear directions), respectively, and calculation of the composite material elastic properties from the measured stresses/strains.

According to an embodiment, the simulation is performed at step 705 by, for instance, employing a linear perturbation analysis that performs six loading conditions for homogenization in one step using Abaqus^{®}. Other known FE solvers or numerical solvers can also be used to perform the simulation. According to another example embodiment of the method 700, the determined at least one property may include at least one of Young's modulus, *e.g.,* 414 (FIG. 4A) or 514 (FIG. 5), and shear modulus, *e.g.,* 416 (FIG. 4B).

Embodiments, *e.g.,* the method 700, can be used as part of a design or development process. For instance, the method 700 can be employed to determine properties of a real-world composite material such as a cement structure, for non-limiting example. In such an embodiment, based on the determined properties, which may indicate that the cement structure is degrading-*e.g*., because pores are expanding over time-alternative design scenarios for the cement structure can be identified. Further, embodiments may be utilized in a development process for a real-world composite material to identify potential formulations for the material with different volume fractions of the constituent components.

### Example Advantages

Embodiments can predict composite material properties under, *e.g.,* carbonation reactions from 3D microstructures, including from noncarbonated to carbonated cement samples. Presented herein are test results on a cement sample and comparisons with laboratory-measured elastic moduli. Existing simulations in the literature do not include an effect of carbonation reactions, and lack a quantitative approach to evaluate how chemical processes change composite material properties. As such, traditional methodologies cannot accurately determine properties of composite materials and cannot accurately evaluate and design real-world structures. Embodiments overcome these and other shortcomings of conventional approaches.

### Computer Support

Embodiments can be implemented in existing software and computer-aided design (CAD) and computer-aided engineering (CAE) platforms. For instance, embodiments can be implemented using features and functionalities of 3DS SIMULIA^{®} software, including the Abaqus^{®} and DigitalROCK^{®} applications by Applicant-Assignee Dassault Systèmes Americas Corporation, among other examples.

FIG. 8 is a schematic view of a computer network in which embodiments may be implemented. Client computer(s)/devices 50 and server computer(s) 60 provide processing, storage, and input/output (I/O) devices executing application programs and the like. Client computer(s)/device(s) 50 can also be linked through communications network 70 to other computing devices, including other client device(s)/processor(s) 50 and server computer(s) 60. The communications network 70 can be part of a remote access network, a global network (*e.g.,* the Internet), cloud computing servers or service, a worldwide collection of computers, local area or wide area networks, and gateways that currently use respective protocols (*e.g.,* TCP/IP, Bluetooth^{®}, etc.) to communicate with one another. Other electronic device/computer network architectures are also suitable.

FIG. 9 is a block diagram illustrating an example embodiment of a computer node (*e.g.,* client processor(s)/device(s) 50 or server computer(s) 60) in the computer network 70 of FIG. 8. Each computer node 50, 60 contains system bus 79, where a bus is a set of hardware lines used for data transfer among components of a computer or processing system. The system bus 79 is essentially a shared conduit that connects different elements of a computer system (*e.g.,* processor, disk storage, memory, I/O ports, network ports, etc.) that enables transfer of information between the elements. Attached to the system bus 79 is an I/O devices interface 82 for connecting various input and output devices (*e.g.,* keyboard, mouse, display(s), printer(s), speaker(s), etc.) to the computer node 50, 60. A network interface 86 allows the computer node to connect to various other devices attached to a network (*e.g.,* the network 70 of FIG. 8). A memory 90 provides volatile storage for computer software instructions 92a and data 94a used to implement an embodiment of the present disclosure (*e.g.,* the method 700 of FIG. 7, etc.). A disk storage 95 provides non-volatile storage for the computer software instructions 92b and data 94b used to implement an embodiment of the present disclosure. A central processor unit 84 is also attached to the system bus 79 and provides for execution of computer instructions.

In one embodiment, the processor routines 92a-92b and data 94a-94b are a computer program product (generally referenced as 92), including a non-transitory, computer readable medium (*e.g.,* a removable storage medium such as DVD-ROM(s), CD-ROM(s), diskette(s), tape(s), etc.) that provides at least a portion of the software instructions for the disclosed system. The computer program product 92 can be installed by any suitable software installation procedure, as is well known in the art. In another embodiment, at least a portion of the software instructions may also be downloaded over a cable, communication, and/or wireless connection. In other embodiments, the disclosure programs are a computer program propagated signal product embodied on a propagated signal on a propagation medium (*e.g.,* a radio wave, an infrared wave, a laser wave, a sound wave, or an electrical wave propagated over a global network such as the Internet, or other network(s)). Such carrier medium or signals provide at least a portion of the software instructions for the present disclosure routines/program 92.

In alternative embodiments, the propagated signal is an analog carrier wave or digital signal carried on the propagated medium. For example, the propagated signal may be a digitized signal propagated over a global network (*e.g.,* the Internet), a telecommunications network, or other networks (such as the network 70 of FIG. 8). In one embodiment, the propagated signal is a signal that is transmitted over the propagation medium over a period of time, such as the instructions for a software application sent in packets over a network over a period of milliseconds, seconds, minutes, or longer. In another embodiment, the computer readable medium of the computer program product 92 is a propagation medium that the computer system 50 may receive and read, such as by receiving the propagation medium and identifying a propagated signal embodied in the propagation medium, as described above for computer program propagated signal product.

Generally speaking, the term "carrier medium" or transient carrier encompasses the foregoing transient signals, propagated signals, propagated medium, storage medium, and the like.

In other embodiments, the program product 92 may be implemented as a so-called Software as a Service (SaaS), or other installation or communication supporting end-users.

Embodiments or aspects thereof may be implemented in the form of hardware including but not limited to hardware circuitry, firmware, or software. If implemented in software, the software may be stored on any non-transient computer readable medium that is configured to enable a processor to load the software or subsets of instructions thereof. The processor then executes the instructions and is configured to operate or cause an apparatus to operate in a manner as described herein.

Further, hardware, firmware, software, routines, or instructions may be described herein as performing certain actions and/or functions of the data processors. However, it should be appreciated that such descriptions contained herein are merely for convenience and that such actions in fact result from computing devices, processors, controllers, or other devices executing the firmware, software, routines, instructions, etc.

It should be understood that the flow diagrams, block diagrams, and network diagrams may include more or fewer elements, be arranged differently, or be represented differently. But it further should be understood that certain implementations may dictate the block and network diagrams and the number of block and network diagrams illustrating the execution of the embodiments be implemented in a particular way.

Accordingly, further embodiments may also be implemented in a variety of computer architectures, physical, virtual, cloud computers, and/or some combination thereof, and, thus, the data processors described herein are intended for purposes of illustration only and not as a limitation of the embodiments.

The teachings of all patents, published applications, and references cited herein are incorporated by reference in their entirety.

While example embodiments have been particularly shown and described, it will be understood by those skilled in the art that various changes in form and details may be made therein without departing from the scope of the embodiments encompassed by the appended claims.

For example, the foregoing description and details of embodiments in the figures reference Applicant-Assignee (Dassault Systèmes Americas Corporation) and Dassault Systèmes tools and platforms, for purposes of illustration and not limitation. Other similar tools and platforms are also suitable.

### References

Bentz, D. P. (1997). Three-dimensional computer simulation of Portland cement hydration and microstructure development. J. Am. Ceram. Soc., 80(1), 3-21.
Bentz, D. P., Mizell, S., Satterfield, S., Devaney, J., George, W., Ketcham, P., Graham, J., Porterfield, J., Quenard, D., & Vallee, F. (2002). The visible cement data set. Journal of Research of the National Institute of Standards and Technology, 107(2), 137.
Huang, J., Krabbenhoft, K., & Lyamin, A. V. (2013). Statistical homogenization of elastic properties of cement paste based on X-ray microtomography images. International Journal of Solids and Structures, 50(5), 699-709.
Kim, J.-S., Lim, J.-H., Stephan, D., Park, K., & Han, T.-S. (2022). Mechanical behavior comparison of single and multiple phase models for cement paste using micro-CT images and nanoindentation. Construction and Building Materials, 342, 127938.
Qin, S., McLendon, R., Oancea, V., & Beese, A. M. (2018). Micromechanics of multiaxial plasticity of DP600: Experiments and microstructural deformation modeling. Materials Science and Engineering: A, 721, 168-178.
Sun, Z., Salazar-Tio, R., Duranti, L., Crouse, B., Fager, A., & Balasubramanian, G. (2021). Prediction of rock elastic moduli based on a micromechanical finite element model. Computers and Geotechnics, 135, 104149.
Zhang, H., Romero Rodriguez, C., Dong, H., Gan, Y., Schlangen, E., & Šavija, B. (2020). Elucidating the effect of accelerated carbonation on porosity and mechanical properties of hydrated portland cement paste using X-ray tomography and advanced micromechanical testing. *Micromachines,* 11(5), 471.

## Claims

1. A computer-implemented method for determining properties of a composite material, the computer-implemented method comprising, by a processor:
obtaining, in a memory, an image of a composite material;
segmenting the obtained image to identify a plurality of phases in the composite material;
based on the obtained image and plurality of phases identified, generating at least one transformed image of the composite material indicating change in the plurality of phases identified;
for each generated at least one transformed image, constructing a finite element (FE) model; and
performing a simulation of the composite material using each FE model constructed to determine at least one property of the composite material.

2. The computer-implemented method of Claim 1, wherein the composite material is concrete or cement.

3. The computer-implemented method of Claim 1 or 2, wherein the change in the plurality of phases identified is a result of a chemical reaction.

4. The computer-implemented method of Claim 3, wherein the chemical reaction is a carbonation reaction.

5. The computer-implemented method of any one of Claims 1 to 4, wherein generating a given transformed image, of the at least one transformed image, based on the obtained image and plurality of phases identified includes:
iterating, until a chemical reaction is completed:
using the obtained image, identifying a contact surface between a first phase and a second phase of the plurality of phases identified, wherein the first phase and the second phase are reactants in the chemical reaction;
determining an exchange, resulting from progression of the chemical reaction, between (i) at least one of the first phase and the second phase and (ii) a product of the chemical reaction; and
based on the exchange determined, updating the obtained image by propagating a conversion from the contact surface identified to the first phase and the second phase until a threshold is met; and
responsive to determining the chemical reaction is completed, generating the given transformed image based on the obtained image updated.

6. The computer-implemented method of Claim 5 wherein, in a first iteration, the contact surface is identified using the obtained image and, wherein, in each iteration subsequent to the first iteration, the contact surface is identified using the obtained image updated, from a previous iteration.

7. The computer-implemented method of Claim 5 or 6, wherein the first phase and the second phase include: (i) a resolved pore and (ii) at least one mineral.

8. The computer-implemented method of any one of Claims 5 to 7, wherein the exchange is a volumetric ratio.

9. The computer-implemented method of any one of Claims 5 to 8, wherein the exchange is determined based on any combination of: (i) density, (ii) porosity, and (iii) stochiometric ratio.

10. The computer-implemented method of any one of Claims 5 to 9, wherein the conversion is propagated based on a three-dimensional (3D) voxel-based growing model.

11. The computer-implemented method of any one of Claims 5 to 10, further comprising:
performing a posterior characterization of the composite material based on the obtained image updated.

12. The computer-implemented method of Claim 11, wherein performing the posterior characterization of the composite material includes:
determining, based on microstructure of the composite material indicated by the obtained image updated, at least one of: (i) elastic moduli and (ii) effective diffusivity.

13. The computer-implemented method of any one of Claims 1 to 12, wherein the segmenting includes:
determining a respective label corresponding to each phase of the plurality of phases identified.

14. The computer-implemented method of Claim 13, wherein a given respective label determined includes one of: (i) a resolved pore, (ii) calcium silicate hydrate (CSH), (iii) portlandite (CH), and (iv) clinker.

15. The computer-implemented method of any one of Claims 1 to 14, wherein each FE model constructed corresponds to a respective porosity of the composite material.

16. The computer-implemented method of Claim 15, wherein performing the simulation includes:
using each FE model constructed corresponding to the respective porosity to determine the at least one property of the composite material as a function of porosity.

17. The computer-implemented method of any one of Claims 1 to 16, wherein the determined at least one property includes at least one of: Young's modulus and shear modulus.

18. The computer-implemented method of any one of Claims 1 to 17, wherein constructing the FE model includes:
configuring, for the FE model, at least one of: (i) a stress boundary condition and (ii) a strain boundary condition.

19. A computer-based system for determining properties of a composite material, the computer-based system comprising:
a processor; and
a memory with computer code instructions stored thereon, the processor and the memory, with the computer code instructions, being configured to cause the computer-based system to perform the method of any one of Claims 1 to 18.

20. A computer program for determining properties of a composite material, the computer program comprising computer code instructions, the computer code instructions being configured, when executed by a processor, to cause an apparatus associated with the processor to perform the method of any one of Claims 1 to 18.
